# EUROPEAN PATENT SPECIFICATION

(11) **EP 3 573 113 B1**
(45) Date of publication and mention of the grant of the patent: **15.04.2020**
(21) Application number: 18174164.6
(22) Date of filing: 24.05.2018
(51) Int. Cl.: H01L 31/05

(54) **PHOTOVOLTAIC MODULE**
FOTOVOLTAISCHES MODUL
MODULE PHOTOVOLTAÏQUE

(43) Date of publication of application: 27.11.2019
(73) Proprietor: Solyco Technology GmbH, 12205 Berlin (DE)
(72) Inventor: Zemen, Yonas, 12205 Berlin (DE); Schultz-Wittmann, Oliver, 12205 Berlin (DE); Podlowski, Lars, 12205 Berlin (DE)
(74) Representative: Eisenführ Speiser

(56) References cited:
- EP-A1- 2 472 597
- EP-A1- 2 924 740
- EP-A1- 3 244 454
- US-A1- 2017 278 986
- US-B2- 6 586 270

## Description

The invention relates to a photovoltaic module and a method for fabricating a photovoltaic module.

A photovoltaic module, herein also referred to in short as module or panel, is formed by a number of photovoltaic cells, which herein also will be called in short cells, which are electrically connected for providing a voltage to an external electrical load.

In US 6,586,270 B2 a process is described for producing a photovoltaic element having an electrode structure comprising a collecting electrode and a metal busbar. The electrode structure is formed by dotting an electrically conductive paste onto a metal wire as the collecting electrode such that the dotted electrically conductive paste has an elliptical form whose major axis and minor axis are respectively perpendicular to and parallel to a lengthwise direction of said metal wire. The metal busbar is then arranged on said dotted electrically conductive paste. A heating step is performed while pressing the resultant structure to cure the electrically conductive paste so as to form a connection between the metal wire as the collecting electrode and the metal busbar.

In US 2017/0278986 A1 interconnecting leads consisting of coated wires connect adjacent solar cells by being soldered to first and second electrodes of adjacent cells.

It is an object of the invention to provide an improved photovoltaic module.

According to a first aspect of the invention, a photovoltaic module according to claim 1 is provided.

The photovoltaic module of the first aspect comprises a plurality of photovoltaic cells. Each of the cells comprises a cell body including a semiconductor body with a photosensitive region for photogeneration of charge carriers in response to absorption of electromagnetic radiation.

The cell body includes an electrically conductive front side surface layer that is arranged on the semiconductor body and forms a front surface of the cell body and that is transparent for the impinging electromagnetic radiation used for the photogeneration of the charge carriers, and an electrically conductive back side surface layer that is arranged on the semiconductor body and forms a back surface of the cell body.

The cells are electrically connected with each other via a plurality of electrically conductive wires configured for providing a voltage to an external electrical load in operation of the module.

The individual wires have a convex outer surface in directions perpendicular to their respective longitudinal wire extension and include a metal core and an electrically conductive and adhesive wire coat that is directly attached and in immediate electrical contact to the front side surface layer or the backside surface layer of a given cell body by means of an electrically conductive adhesive bond.

Thus, when exposed to light, the individual cells generate charge carriers, i.e., electrons and holes via the photovoltaic effect, in response to the absorption of electromagnetic radiation. Since the individual wires include a metal core and an electrically conductive and adhesive wire coat that is directly attached and in immediate electrical contact to the front side surface layer or the backside surface layer of a given cell body by means of an electrically conductive adhesive bond, the individual wires collect photogenerated charge carriers from a respective cell. In addition, since the plurality of electrically conductive wires is at the same time used for electrically connecting the cells with each other, the provision of a voltage to an external electrical load by the photovoltaic module is achieved using a single type of conductive wires. In other words, any given electrically conductive wire collects photogenerated charge carriers in a given cell of the module from the respective cell body and also transports them all the way to another cell of the module by the same electrically conductive wire.

In contrast, US 6,586,270 B2 describes a photovoltaic cell in which the functionalities of collecting and transporting are performed by separate types of wiring. Namely, a large number of grid fingers, called collecting electrodes in US 6,586,270 B2, are used for carrier collection and form a first type of wiring. These grid fingers are attached and, only at particular contact points, in direct contact to a small number of busbars The busbars are arranged on top of the grid fingers and connected with the grid fingers at these contact points using an electrically conductive paste. The busbars transport the collected charge carriers to the respective next cell and thus form a second type of wiring, which is different from the grid fingers.

In accordance with the present invention, therefore, every individual wire is used to both collect photogenerated charge carriers via the electrically conductive front side surface layer and to transport the collected charge carriers all the way from the point of collection to the respective next neighboring cell. As a consequence, the individual wires of the photovoltaic module of the present invention do not have any point of direct mutual contact with each other. The lack of contact points with other wires avoids potential electrical losses due to contact failure potential that always exists at such contact points.

For clarity, it is to be understood that of course not a single wire, but a suitable plurality of wires of the type described in the following is used. In accordance with the present invention, all individual wires have a convex outer surface in directions perpendicular to their respective longitudinal wire extension and include a metal core and an electrically conductive and adhesive wire coat that is directly attached and in immediate electrical contact to the front side surface layer or the backside surface layer of a given cell body by means of an electrically conductive adhesive bond.

The described wiring concept of the photovoltaic module of the present invention advantageously simplifies the fabrication process of the cells or the module in that it requires particularly few fabrication steps. In particular, no metallisation step is required during fabrication of the cells. Any metallisation if necessary is made during subsequent fabrication of the module. Also, for fabricating the cells it is not required to establish any electrical contact points between different wires on the respective cell. In this regard, the wiring concept also increases the reliability of the cells in operation, because the cells have no risk of contact failure that such electrical contact points between the grid fingers and the busbars used in the prior art would constitute.

Establishing the adhesive bond is a comparatively gentle process for directly attaching the individual wires and bringing them in immediate electrical contact to the front side surface layer or the backside surface layer. In particular, this process allows avoiding high pro-cessing temperatures, for example in comparison with known standard wiring concepts in which a connection between a front side surface layer and grid fingers is established by soldering, as are the connections between the grid fingers and the busbars. Soldering necessarily requires comparatively high temperatures, typically in the range between 230°C to 260°C, and bears a risk of cracking or damaging of the cells when cooling down the cells to room temperature after soldering. A reason for this undesired risk of damage lies in a difference of coefficients of thermal expansion of the wires and the cell material. Thus, since establishing an adhesive bond under relatively low processing temperatures requires subsequent cooling of the cell or module from processing temperatures, which are lower compared to the processing temperature of a soldering, a significant reduction of the amount of mechanical stress for the cells is achieved. This allows achieving a particularly low rate of rejected cells and modules in the fabrication process, and a long lifetime of the photovoltaic module of the present invention. Also, cells having a particularly low thickness can be fabricated without risk of mechanical damage.

As mentioned, to transport photogenerated electrical current of an amount required in many application cases, use of a larger number of wires may be suitable or required. This bears a risk of increasing optical losses due to an increasing covered or shaded area of the surface of the cell body and reflection from wiring. In the module of the first aspect of the invention, electrical losses are reduced by a convex outer surface of the individual wires in directions perpendicular to their respective longitudinal wire extension. The convex surface provides a particular geometry for scattering or reflection of impinging light, allowing to achieve a high fraction of light that is initially scattered by a given wire but eventually redirected by a single or multiple scattering events onto active parts of the surface of the cell, which are not covered by wires.

As a brief summary, thus, by the combination of its features, the photovoltaic module of the present invention achieves substantial advantages in fabrication as well as operation and is recognizable in particular by its characteristic front pattern having non-crossing wires with a convex outer surface on the cells, which do not have any grid fingers.

In the following, embodiments of the photovoltaic module of the first aspect of the invention will be described.

It is not an essential requirement that the adhesive bond between the individual wires and the front side surface layer or the backside surface layer of a given cell body extend continuously over the full length of the respective surface. In preferred embodiments, however, to optimize the efficiency of carrier collection, the adhesive bond between the individual wires and the front side surface layer or the backside surface layer of a given cell body does extend continuously across the front surface or the back surface of the cell body. This allows the wires collecting photogenerated charge carriers directly at the front surface or the back surface at any point along the extension of the adhesive bond, which in particular embodiments reaches from a first edge to an opposite second edge of the cell body.

Suitable materials for the front side surface layer are transparent and electrically conductive materials. Both inorganic and organic materials can be used. Suitable inorganic materials are for instance transparent conducting oxides (TCOs), such as indium tin oxide (ITO), fluorine doped tin oxide (FTO) or doped zinc oxide. Suitable carbon-based or organic materials include graphene or polymers.

In a preferred embodiment, the front side surface layer is anti-reflective for those spectral components of impinging electromagnetic radiation that are used for the photogeneration of the charge carriers. Thus, reflection losses are reduced in that electromagnetic radiation impinging through the transparent front side surface layer and reflected from the surface of the semiconductor body is reflected back from the air interface of the front side surface layer towards the semiconductor body and can thus also be exploited for the photogeneration of the charge carriers.

The backside surface layer may be implemented in different ways. In one embodiment, the backside surface layer is anti-reflective and transparent for those spectral components of impinging electromagnetic radiation that are used for the photogeneration of the charge carriers. In this embodiment, the backside surface layer is implemented in the same way as described for the front side surface layer of the embodiment described in the last paragraph. In other words, in this embodiment electromagnetic radiation impinging on the back side of the semiconductor body can also contribute to the photogeneration of charge carriers.

In another, alternative embodiment, however, the back side surface layer is made of a metal that is resistant to oxidation. A metal back side surface layer is highly reflective such that electromagnetic radiation impinging on the front side surface layer and traversing the semiconductor body is reflected back into the semiconductor body and used for the photogeneration of charge carriers. As the metal back side surface layer is resistant to oxidation, a formation of a dielectric oxide layer on the back side surface layer is prevented. This is advantageous as wires can be attached to and brought into direct electrical contact with the back side surface layer of a given cell by means of an adhesive bond at a later stage during module fabrication without risking the formation of an electrically isolating oxide layer on the back side surface layer in the meantime. While in general embodiments can have the cells electrically connected in any suitable way, preferred embodiments have the cells electrically connected via the plurality of wires to form a series connection of the cells for providing the voltage to the external electrical load. Preferably, in these preferred embodiments, a front set of the wires runs on the front surface of the cell body of a given cell and is guided to the back surface of the cell body of a cell that is next in the series connection. In an alternative, currently non-preferred embodiment, the cells are electrically connected via the plurality of wires to form a parallel connection of the cells for providing an open circuit voltage to an external electrical load.

In the following, embodiments with specific advantageous properties of the wires will be described. For a given wire the electrical resistance losses grow to the square with increasing current amount, whereas the resistivity of the wire decreases linearly with increasing cross-section. Therefore, it has been considered beneficial in the prior art to use many wires with small cross sections rather than a few thicker wires. In order to facilitate such concepts, it is known to design wiring patterns using a large number of very narrow and flat grid fingers for collecting current over the area of the cell and for conducting the current to broad busbars, which are usually made of flat, tin-plated copper wire. Such solar cell wiring patterns usually have between 2 and 12 busbars.

However, the flatness of the busbars causes shading of the solar cell which is an additional contributor to the optical losses. In comparison, as described hereinabove, the convex outer surface of the wires in the module of the present invention provides an advantageous geometry for reducing optical losses due to scattering or reflection of impinging light by the wires. The convex outer surface of the wires can be implemented in many different ways. Preferably, the electrically conductive wires have a round shape in cross sectional planes perpendicular to their longitudinal extension. The round shape is in some embodiments elliptical. Even more preferably, the wires have a substantially circular cross section.

It is thus desired to optimize size and number of wires (per unit length) in a way that is suited for balancing both optical and electrical losses to achieve the smallest possible values. A circular or at least approximately circular shape is a particularly suitable shape for minimizing both optical and electrical losses. Compared, e.g., to flat wires of the same lateral extension, electrical losses are reduced by the larger cross sectional area of the circular-shaped wires. At the same time, optical losses are reduced, as explained above. An actual number for a given application case depends, among others, on the size of the cell, the size and specific conductivity of the wire material, and on the conductivity of the front side surface layer. Regarding wire size, preferably, an extension of the metal core in directions perpendicular to the longitudinal extension of the wire is between 50 and 400 micrometres.

For a circular wire shape, thus, the wire diameter is preferably between 50 and 400 micrometres. For an elliptical wire shape, the same applies for the major and minor axes, which each are between 50 and 400 micrometres, but different from each other. In some embodiments the cells comprise 10 to 40 wires per 0,1 meter, counted in a direction perpendicular to a longitudinal extension of the wires. In such embodiments, every wire only needs to transport a current of less than 1 Ampere, which keeps electrical losses small. Counted for a given cell, depending also on the cell size, some advantageous embodiments thus have an amount of 10 to 70 wires of the mentioned size on each surface of the given cell. For example, embodiments employing a typical cell size of 157 x 157 mm² preferably have 15 to 61 wires per surface.

Suitably, all wires are arranged with equal spacing, i.e., at equal distance from each other.

For keeping electrical loss small, the metal core of the wires is preferably made of copper, aluminum, nickel or an alloy containing at least two of these metals. This list is meant for giving non-limiting examples suitable in general. The use of another metal may be indicated in specific application cases.

In an embodiment, the metal core is covered by a non-corrosive plating. Preferably, the non-corrosive plating is made of silver. The silver layer has the advantage of achieving a more reliable electrical contact to many electrically conductive adhesives used for the adhesive wire coat than the wire core metal, such as copper.

Materials suitable for use as the electrically conductive adhesive wire coat are generally known per se in the art. The electric conductivity is suitably caused by particles made of a conductive component such as silver, nickel, copper or graphite, carbon black, indium oxide, tin oxide, indium tin oxide (ITO), or zinc oxide. The particles of the conductive component are present in an amount that established contact among each other (e.g., 80 % of the mass) and in this way make electric current possible. This conductive component is suspended in an adhesive component that holds the electrically conductive adhesive together. The adhesive component can be a polymer resin, synthetic resin, epoxy resin, varnish, or silicone. A specific example of an electrically conductive adhesive is a high-viscosity electrically conductive liquids such as silver-filled epoxy. Another example of a suitable electrically conductive adhesive is an electrically conductive sticking tape.

Preferably, the electrically conductive adhesive wire coat has a thickness between 20 and 40 micrometres. In a preferred embodiment, the electrically conductive adhesive wire coat is formed by a single layer of an electrically conductive adhesive material.

The wire coat of some embodiments is black for satisfying aesthetic market requirements. However, for improving optical properties, a white or colourless transparent wire coat is preferred. In particular, these types of wire coat have the advantage that electromagnetic radiation is reflected from the wire coat or from the metal core towards the cell, respectively, and can be used for the photogeneration of the charge carriers despite initially hitting the wire. In the operation of the module, a large amount of electromagnetic radiation reflected back from the wires is advantageously redirected towards the cells by (total) reflection form a transparent cover of the module. The convex geometrical profile of the wires enhances this effect.

In a preferred embodiment, the adhesive wire coat, seen in a cross sectional view, comprises an inner coat layer contacting the metal core (or, if present, a non-corrosive plating surrounding the metal core) and an outer coat layer enclosing the inner coat layer and forming the adhesive bond to the cell body.

It is preferred that the semiconductor body is a crystalline silicon body. The silicon body of some embodiments has with a relatively thin n-doped emitter layer close to the front surface of the cell body and a much thicker p-doped base layer extending to the back surface of the semiconductor body. The base is the photosensitive region used for photogeneration of charge carriers in response to absorption of electromagnetic radiation, and also called the active layer. In embodiments forming a heterojunction cell, the semiconductor body is formed by a sequence of a doped layer of hydrogenated amorphous silicon (a-Si:H) of a first conductivity type, an undoped a-Si:H layer, a crystalline doped Silicon body of a second conductivity type, an undoped a-Si:H layer, and an a-Si:H layer of the second conductivity type. In a preferred variant of this embodiment, the first conductivity type is a p-type conductivity, and the second conductivity type an n-type conductivity.

In a group of embodiments, the cell body additionally includes an electrically conductive passivation layer, which is arranged directly on a surface of the semiconductor body. The passivation function of the passivation layer lies in a reduction of surface recombination of the photogenerated charge carriers.

The passivation layer is in some variants of this group provided only on the front surface of the semiconductor body. In other variants, it is only provided on the back surface of the semiconductor body. In yet another group of variants, it is provided on the front surface as well as on the back surface of the semiconductor body.

The passivation layer is in some variants provided in addition to the electrically conductive front side surface layer or back side surface layer, respectively. In this case, thus, the passivation layer is arranged between the semiconductor body and the front side surface layer or back side surface layer.

In some embodiments, which have no additional passivation layer, the front side surface layer or backside surface layer at the same time has a passivation function. A passivation layer can be made of, e.g., silver or nickel, SiC or Al₂O₃ or a combination thereof.

According to a second aspect of the invention, a method for fabricating a photovoltaic module is provided. The method includes the steps of
- for each cell:
   - fabricating a cell body including a semiconductor body with a photosensitive region for photogeneration of charge carriers in response to absorption of electromagnetic radiation
   - arranging an electrically conductive front side surface layer that is transparent for the impinging electromagnetic radiation used for the photogeneration of the charge carriers on the semiconductor body, thus, forming a front surface of the cell body, and
   - arranging an electrically conductive back side surface layer on the semiconductor body, thus, forming a back surface of the cell body; the method further comprising
- electrically connecting the cells via a plurality of electrically conductive wires that have a convex outer surface in directions perpendicular to their respective longitudinal wire extension and include a metal core and an electrically conductive and adhesive wire coat, by forming an adhesive bond between the adhesive wire coat of the individual wires and the front side surface layer or the backside surface layer of a given cell body.

The method advantageously simplifies the fabrication process of the cells in that it requires particularly few fabrication steps. No metallisation step is required anymore in the fabrication of the cells. In this context, for fabricating the cells it is also not required anymore to establish any electrical contact points between different conductors, such as grid fingers and busbars on the cells. In this regard, the method also increases the reliability of the fabricated cells and thus of the module as a whole, because the risk of contact failure is avoided that such electrical contact points between the grid fingers and the busbars used in the prior art would constitute.

Establishing the adhesive bond is a comparatively gentle process for directly attaching the individual wires and bringing them in immediate electrical contact to the front side surface layer or the backside surface layer. In particular, this process allows avoiding high pro-cessing temperatures. Thus, a significant reduction of the amount of mechanical stress for the cells due to an existing mismatch of the coefficients of thermal expansion is achieved. This allows achieving a particularly low rate of rejected cells and modules in the fabrication process, and a long lifetime of photovoltaic module of the present invention. Also, cells having a particularly low thickness can be fabricated without risk of mechanical damage.

In the following, further embodiments will be described with reference to the Figures.

In the Figures:
- Fig. 1: shows a photovoltaic cell comprising cell body and individual wires arranged on a front side and on a back side of the cell body;
- Fig. 2: shows a photovoltaic cell comprising cell body and individual wires arranged on a front side of the cell body;
- Fig. 3: shows a photovoltaic cell comprising cell body and individual wires arranged on a back side of the cell body;
- Fig. 4: shows two cells that are cells out of a plurality of cells which are electrically connected to form a photovoltaic module;
- Figs. 5 to 10: schematically show an embodiment a method for fabricating a cell body of a photovoltaic cell by way of a series of intermediate products at different processing stages of the method;
- Figs. 11 to 16: schematically show another embodiment a method for fabricating a cell body of a photovoltaic cell by way of a series of intermediate products at different processing stages of the method;
- Figs. 17 to 20: schematically show wires in a cross sectional view that can be attached to photovoltaic cells; and
- Figure 21: shows a cross sectional view of a further embodiment of a photovoltaic cell.

Before turning to the description of the drawings, it is noted that the drawings shown are schematic. In particular, the views shown in the drawings are not drawn to scale and are not intended to represent any geometrical relationships between different layers or other structural features shown. Where wires are shown in the drawings, the respective number of wires shown is selected for merely explanatory reasons without intending to suggest that the shown number of wires is a suitable choice for the embodiment of a photovoltaic cell represented by the given drawing. The drawings do not show known standard features for packaging. As is well known, a photovoltaic module is a packaged and connect assembly of photovoltaic cells. The present graphical representations, for reasons of simplicity, do not show packaging features for protecting the cells and the module, in particular from mechanical damage and moisture.

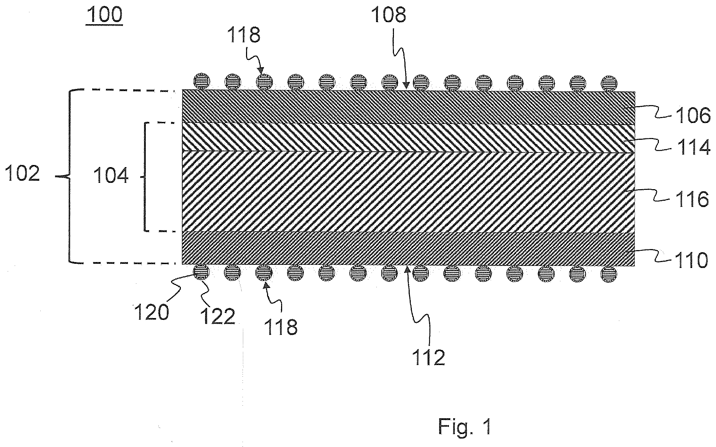

Figure 1 shows a photovoltaic cell 100 comprising a cell body 102. The cell body 102 includes a semiconductor body 104, an electrically conductive front side surface layer 106 and an electrically conductive back side surface layer 110.

The semiconductor body 104 is a silicon crystalline body that in the present embodiment has a relatively thin n-doped emitter layer 114 close to a front surface 108 of the cell body 102 and a much thicker p-doped base layer 116 extending to a back surface 112 of the semiconductor body 104.

The base layer 116 is the photosensitive region used for photogeneration of charge carriers in response to absorption of electromagnetic radiation. Thus, when exposed to light, the cell 100 generates charge carriers, i.e., electrons and holes via the photovoltaic effect, in response to the absorption of electromagnetic radiation.

In a variant that is not shown, the n-doped emitter layer 114 is not arranged close to the front side 108, but close to the back side 112 of the cell body. In this case, the p-doped base layer 116 is arranged close to the front side 108 of the cell body.

In another embodiment not shown, a p-doped emitter is used and arranged either close to the front or the back side of the cell body, and an n-doped base layer is arranged close to the respective opposite side, i.e., the back or the front side of the cell body.

Returning to the photovoltaic cell 100 shown in Fig. 1, the front side surface layer 106 is arranged on the semiconductor body 104 and forms the front surface 108 of the cell body 102. The front side surface layer 106 is anti-reflective for those spectral components of impinging electromagnetic radiation that are used for the photogeneration of the charge carriers. Thus, reflection losses during operation of the cell can be reduced in that electromagnetic radiation impinging through the transparent front side surface layer 106 and reflected from the surface of the semiconductor body 104 is reflected back from the air interface of the front side surface layer 106 towards the semiconductor body 104 and can thus also be exploited for the photogeneration of the charge carriers.

The back side surface layer 110 is arranged on the semiconductor body 104 and forms the back surface 112 of the cell body 104. The backside surface layer 110 is implemented in the same way as the front side surface layer 106 and is thus anti-reflective and transparent such that electromagnetic radiation impinging on the back side 112 of the semiconductor body 104 can also contribute to the photogeneration of charge carriers.

In a variant that is not shown, the cell body 102 additionally includes an electrically conductive front side passivation layer between the semiconductor body 104 and the front side surface layer 106. A back side passivation layer may additionally or alternatively also be arranged between the semiconductor body 104 and the back side surface layer 110.

In other embodiments that are not shown, a back side surface layer is made of a metal that is resistant to oxidation and highly reflective such that electromagnetic radiation impinging on a front side surface layer and traversing a semiconductor body is reflected back into a semiconductor body and used for the photogeneration of charge carriers.

The cell 100 of the present exemplary embodiment has a size of approximately 157 times 157 mm², which is one of the known standard sizes often used for photovoltaic cells. However, the cell size is not an essential feature and can be selected according to the requirements of a given application case.

In the exemplary embodiment of Fig. 1, wires 118 are arranged on both the front side 108 and the back side 112 of the cell body 102. In the present example, 14 individual wires 118 are shown on the front surface 108 and 14 individual wires 118 are shown on the back surface 112. However, this number has been selected for the purpose of graphical representation. A suitable number of wires is to be selected according to application-specific requirements and suitably determined by an optimization taking into account boundary conditions regarding optical losses, in particular by shading and reflection, electrical losses in view of material selection, output power requirements, etc. For a given wire, electrical resistance losses grow to the square with increasing current value, whereas the resistivity of a wire only reduces linearly with increasing cross-section. Therefore, it is preferable to select a larger number of wires with smaller wire cross sections in comparison with only a few thicker wires. Suitable designs of the cell 100 comprise between 10 and 40 wires per 0,1 meter (i.e., 10 centimeter or 3,9 inch), counted in a direction perpendicular to a longitudinal extension of the wires. In such embodiments, in operation of the cell 100, every wire 118 only needs to transport a current of less than 1 Ampere, which keeps the electrical losses small.

The electrically conductive wires 118 are equally spaced to each other. Thus, the individual wires 118 do not have any point of direct mutual contact with each other. The lack of contact points with other wires avoids potential electrical losses that may occur at such contact points.

In the present embodiment, the wires 118 have a round shape in cross sectional planes perpendicular to their longitudinal extension. In other embodiments that are not shown, electrically conductive wires have an elliptical shape. A circular or at least approximately circular shape is a particularly suitable shape for minimizing both optical and electrical losses in comparison with interconnectors of known photovoltaic cells that usually consist out of flat, tin-plated copper wire. In such known photovoltaic cells, the flat side is connected to the cell. Its flatness causes shading of the solar cell which is a contributor to optical losses.

Each of the wires 118 includes a metal core 120 and an electrically conductive and adhesive wire coat 122. In embodiments, in which the wires 118 have a substantially circular cross section, the diameter of the metal core is suitably between 20 and 400 micrometres. A smaller diameter is preferred to achieve a smaller wire diameter. A smaller wire diameter allows arranging a larger number of wires and thus improve carrier collection from the front surface layer 108 and reduce electrical losses due to the electrical resistance of the front surface layer 108. In some embodiments the diameter reaches a value even smaller than 20 micrometres.

The metal core of the wires 118 is made of copper, aluminum, nickel or an alloy containing at least two of these metals.

The conductive adhesive wire coat 122 has a thickness between 30 and 40 micrometres. For instance, a thickness of 35 micrometres can be used. In the present exemplary embodiment, the adhesive wire coat is made of a silver-filled epoxy. In other embodiments that are not shown, the material of the adhesive wire coat is a polymer resin, synthetic resin, epoxy resin, varnish, or silicone. The adhesive wire coat comprises electrically conductive particles made of a conductive component such as silver, nickel, copper or graphite, carbon black, indium oxide, tin oxide, indium tin oxide (ITO), or zinc oxide to ensure a high electric conductivity of the wire coat.

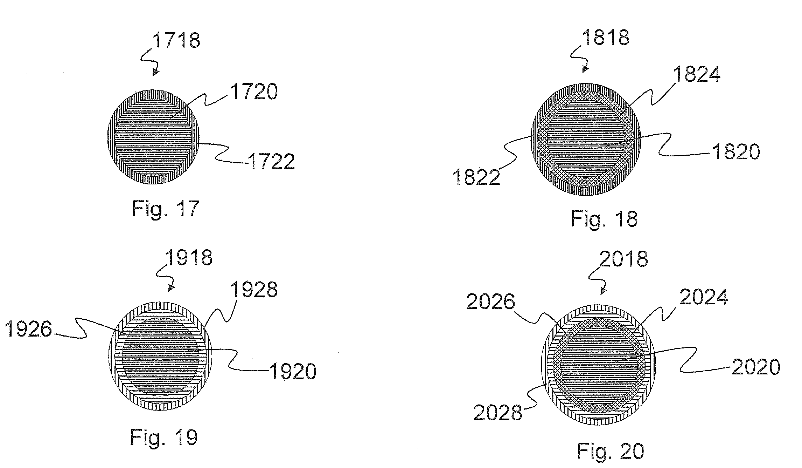

Further alternative cross-sectional structures of wires suitable for use in the context of the present invention will be described further below in the context of the Figs. 17 to 20. For example, while in the present embodiment, the wire coat 122 is directly arranged on the metal core 120, another embodiment shown further below comprises a metal core that is surrounded by a non-corrosive plating followed by the adhesive wire coat (cf. Fig. 18).

The wire coat 122 is directly attached and in immediate electrical contact to the front side surface layer 106 or the backside surface layer 110 of the cell body 104, respectively, by means of an electrically conductive adhesive bond. While it is not an essential requirement that the adhesive bond between the individual wires and the front side surface layer 106 or the backside surface layer 110 of the cell body 102 extend continuously over the full length of the respective surface, it is however preferred in order to optimize the efficiency of carrier collection. Thus, in the present embodiment, the adhesive bond between the individual wires and the front side surface layer or the backside surface layer extends continuously across the front surface 108 and the back surface 112 of the cell body 102. This allows the wires 118 collecting photogenerated charge carriers directly at the front surface or the back surface at any point along the extension of the adhesive bond, which suitably reaches from a first edge to an opposite second edge of the cell body 102, seen in a direction perpendicular to the paper plane of Fig. 1, i.e., along the longitudinal extension of the wires 118.

This wiring concept of the photovoltaic cell 100 also simplifies the fabrication process of the cell and of a module comprising the cell in that it requires particularly few fabrication steps. In particular, for fabricating the cell, no metallization is required, and it is not required to perform soldering to establish electrical contact with the front side or back side surface layer of the cell body 102, nor any electrical contact points between different wires. In this regard, the wiring concept also increases the reliability in operation, because there is no risk of contact failure that such electrical contact points used between grid fingers and busbars known from the prior art would constitute.

Since in the embodiment of Fig. 1, all individual wires 118 are directly attached and in immediate electrical contact to the front side surface layer 106 or the backside surface layer 110 of the cell body 102 by means of the electrically conductive adhesive bond along their full longitudinal extension, a particularly high efficiency of carrier collection is achieved.

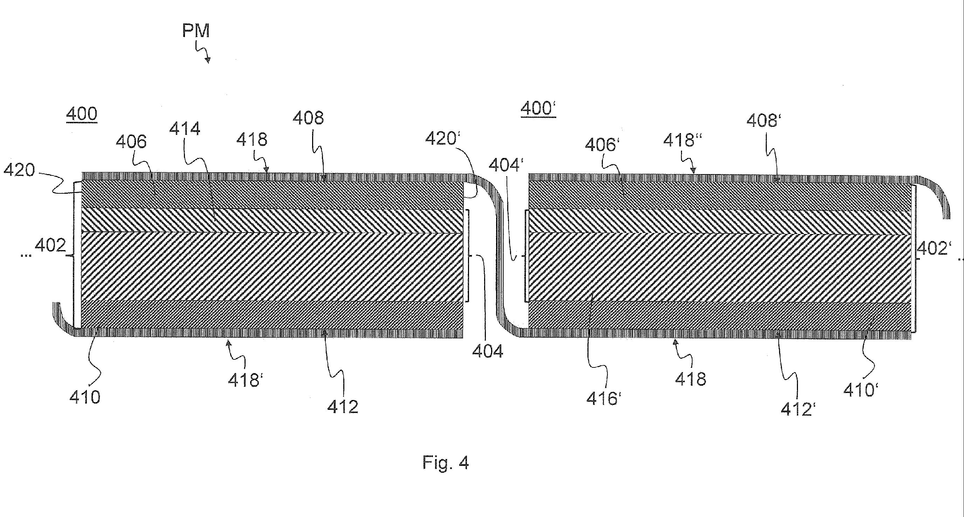

Photovoltaic cells such as the cell 100 therefore produce a high current, reaching for instance current amounts of almost 10A. This current amount needs to get transported with minimum electrical losses from one cell to the next in order to reach optimized output power of a photovoltaic module (see Fig. 4). In this regard, it is advantageous that the individual wires 118, as part of a photovoltaic module, are at the same time used for directly electrically connecting the cell 100 with other cells of a module and transport the generated charge carriers to the next cell. In other words, the individual wires of the photovoltaic module of the present invention do not have any point of direct mutual contact with each other. The lack of contact points with other wires avoids potential electrical losses that may occur at such contact points.

Further advantages of a photovoltaic module that comprise a plurality of photovoltaic cells described hereinabove will be explained further below in the context of Fig. 4.

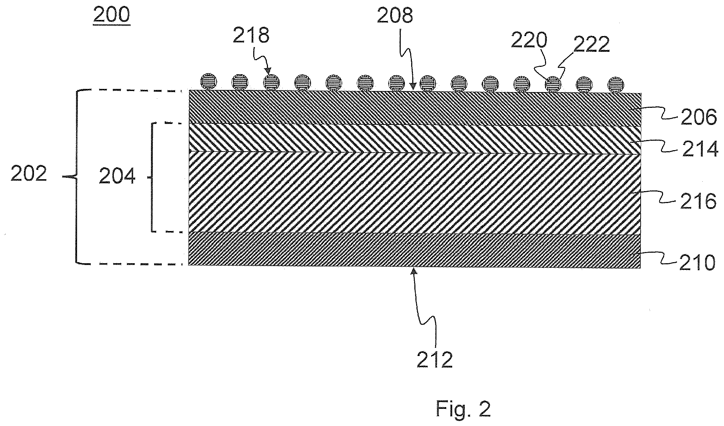

Figure 2 shows, as a variant of the photovoltaic cell 100, a photovoltaic cell 200. The cell 200 is generally configured as described with respect to Fig. 1. For that reason, the reference labels used in Fig. 2 for given structural elements resemble those used in Fig. 1 for corresponding structural elements, except for the first digit, which is a "2" instead of a "1". Thus, reference is made in parallel to the description of the photovoltaic cell of Fig. 1. The following description focusses on the differences between the cells 100 and 200.

Instead of having individual wires 218 arranged on the front side and on back side of the cell 202 as was shown in Fig. 1, individual wires 218 of the cell 200 of Fig. 2 are arranged on the front side 208 of the cell 200 only. Otherwise, the wires 218 are configured in the same way as the individual wires described with respect to Fig. 1. In particular, thus, each of the wires 218 includes a metal core 220 and an electrically conductive and adhesive wire coat 222 that is directly attached and in immediate electrical contact to the front side surface layer 206 of the cell body 202 by means of an electrically conductive adhesive bond.

The cell 200 can be used in a photovoltaic module as an "end cell", i.e., as the first or last cell in a series connection of photovoltaic cells. Additional wiring to be used for connecting the cell 200 to an external electrical load is known in the art per se and not shown here for simplicity.

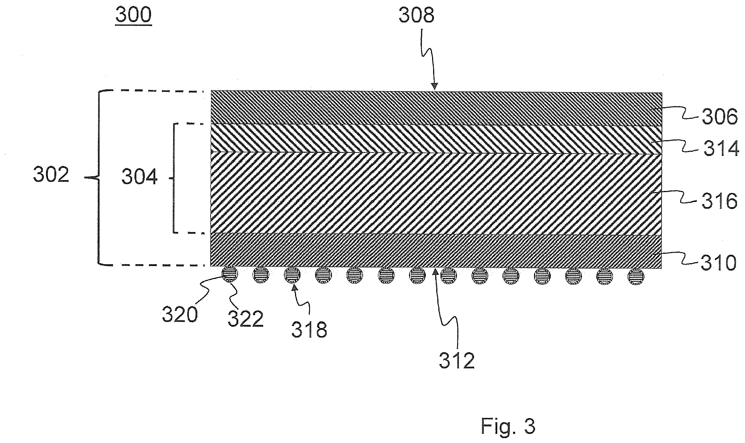

Figure 3 shows, as a further variant of the photovoltaic cell 100, a photovoltaic cell 300. The cell 300 is generally configured as described with respect to Fig. 1. For that reason, the reference labels used in Fig. 3 for given structural elements resemble those used in Fig. 1 for corresponding structural elements, except for the first digit, which is a "3" instead of a "1". Thus, reference is made in parallel to the description of the photovoltaic cell of Fig. 1. The following description focusses on the differences between the cells 100 and 300.

Instead of having individual wires 318 arranged on the front side and on back side of the cell 302, as was shown in Fig. 1, individual wires 318 of the cell 300 of Fig. 3 are arranged on the back side 312 of the cell 300 only. Otherwise, the wires 318 are configured in the same way as the individual wires described with respect to Fig. 1. In particular, thus, each of the wires 318 includes a metal core 320 and an electrically conductive and adhesive wire coat 322 that is directly attached and in immediate electrical contact to the back side surface layer 310 of the cell body 302 by means of an electrically conductive adhesive bond.

As for the cell 200, the cell 300 can be used in a photovoltaic module as an "end cell", i.e., as the first or last cell in a series connection of photovoltaic cells. Again, additional wiring to be used for connecting the cell 300 to an external electrical load is known in the art per se and not shown here for simplicity.

Figure 4 shows a sectional view of a photovoltaic module PM comprising a plurality of cells which are electrically connected to form the photovoltaic module.

For further simplicity, only two cells 400, 400' are shown. Each of the cells 400,400' and its constituents are configured as described with respect to Fig. 1. The cells 400, 400' are generally configured as described with respect to Fig. 1. For that reason, the reference labels used in Fig. 4 for given structural elements resemble those used in Fig. 1 for corresponding structural elements, except for the first digit, which is a "4" in-stead of a "1". It is noted that the cross sectional plane shown in Fig. 4 is at 90 degrees with respect to the cross sectional plane shown in Figs. 1 to 3.

Thus, each of the cells 400, 400' of the photovoltaic module PM comprises a cell body 402, 402' that includes a semiconductor body 404, 404', an electrically conductive front side surface layer 406, 406' and an electrically conductive back side surface layer 410, 410' that is arranged on the semiconductor body 404, 404' and forms a back surface 412, 412' of the cell body 402, 402'. The front side surface layer 406, 406' forms a front surface 408, 408' of the cell body 402, 402', and the back side surface layer 410, 410' forms a back surface 412, 412' of the cell body 402, 402'.

The cells of the photovoltaic module PM are connected electrically in a series connection. In particular, the two cells 400, 400' are electrically connected with each other via the plurality of electrically conductive wires 418. It is to be kept in mind that due to the viewing direction, only one of the wires 418 is visible in Fig. 4 and shown along its longitudinal extension. The cells 400, 400' are further electrically connected to their other neighboring cells of the series connection, which are not shown, via the wires 418', 418".

It can thus be seen that the series connection establishes an electrical contact between the n-doped emitter layer 414 of cell 400 and the p-doped base layer 416' of the next cell 400' via the respective electrically conductive front side and back side surface layers 406 and 410'.

Accordingly, the plurality of wires 418 runs on the front surface 408 of the cell body 402 of cell 400 and is guided to the back surface 412' of the cell body 402' of the cell 400' that is next in the series connection. To optimize the efficiency of carrier collection, the adhesive bond between the wire 418 and the front side surface layer 406 of cell 400 and the backside surface layer 410' of the cell body 402' of the cell 400' next in series extends continuously over the full length of the respective surfaces 408, 412'. This allows the wire 418 to collect photogenerated charge carriers directly at the front surface 408 at any point along the extension of the adhesive bond, which extends from a first edge 420 to an opposite second edge 420' of the cell body 402.

The wires 418' 418" that are also the foremost wires out of a plurality of wires indicate, that each of the cells 400, 400' is connected in series with next cells of a photovoltaic module in the same manner as described with respect to the electrical connection of cells 400, 400' via the plurality of wires that also comprises the wire 418.

While the example of Fig 4 has electrical connections made in series to achieve a desired output voltage, it is also possible as an alternative to make electrical connections in parallel to provide a desired current capability.

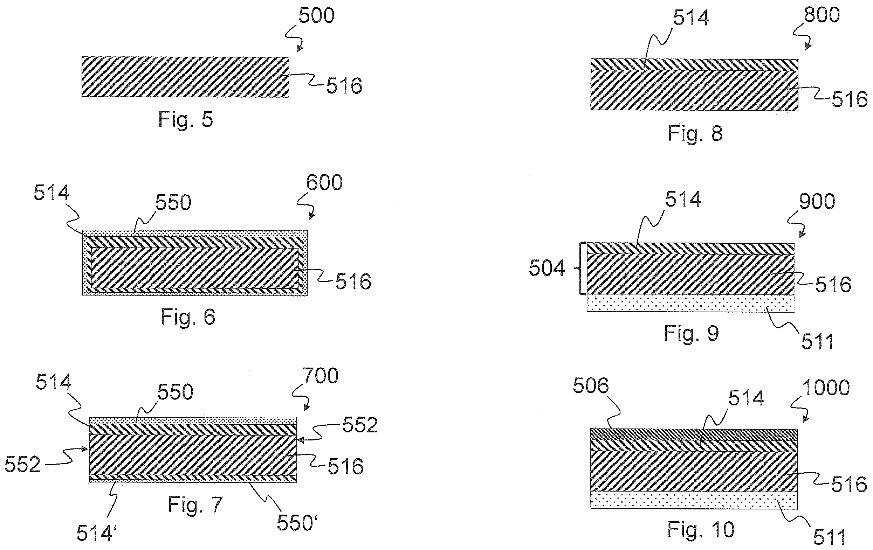

Figures 5 to 10 schematically show an embodiment of a method for fabricating a cell body of a photovoltaic cell by way of a series of intermediate products at different processing stages of the method. In the following, reference will be made to Figs. 5 to 10 in parallel.

Figure 5 shows, as a starting product 500 of a first processing stage, a p-type silicon wafer 516, which eventually will serve as a base layer of a cell body 1000 of a photovoltaic cell.

After defect etching and cleaning, as well as POCl₃ diffusion, an intermediate cell product is obtained that additionally comprises an n-doped emitter layer 514 followed by an oxide layer 550. Both the emitter layer 514 and the oxide layer 550 surround the remaining p-doped regions 516 of the silicon wafer. This processing stage is visualized by way of an intermediate cell body 600 shown in Fig. 6.

After a subsequent edge isolation step, an intermediate cell product 700 is obtained, in which the oxide layer 550 as well as the n-doped layer 516 are removed from side faces 552 of the intermediate cell body 700 shown in Fig. 7. Thus, n-doped layers 514, 514' are arranged on the front side and back side, each covered by an oxide layer 550, 550'.

In an oxide etching and cleaning step, the oxide layers 550, 550' and the n-doped layer 514' are removed such that an intermediate cell product 800 is obtained, comprising the silicon wafer 516 and the n-doped layer 514 on the front of the wafer 516as indicated in Fig. 8. The n-doped layer 514 arranged on the front side of the wafer 500 is to function as the emitter layer of the cell body 1000.

After a backside AI printing step, an intermediate cell product 900 shown in Fig. 9 is obtained. It comprises a back side surface layer 511. In the present method, the back side surface layer 511 is made of aluminum. Aluminum is a metal that is both electrically conductive and highly reflective such that electromagnetic radiation impinging on the front side surface layer and traversing a semiconductor body 504 is reflected back into a semiconductor body 504 and used for the photogeneration of charge carriers. At the same time, the aluminum backside surface layer allows conducting the electrical current between neighboring photovoltaic cells with particularly low electrical losses.

The cell body 1000 shown in Fig. 10 is obtained after a next processing stage, which includes firing and depositing a transparent conductive oxide layer as the front side surface layer 506.

In a successive processing step, individual electrically conductive wires, e.g., wires as shown in Figs. 17 to 20, are directly attached to the front side surface layer 506 or the backside surface layer 511 of the cell body 1000 by means of an electrically conductive adhesive bond. Establishing the adhesive bond is a comparatively gentle process for directly attaching the individual wires and bringing them in immediate electrical contact to the front side surface layer or the backside surface layer. In particular, this process allows avoiding high processing temperatures. Since establishing an adhesive bond under relatively low processing temperatures requires subsequent cooling of the cell or module from pro-cessing temperatures, which are lower compared to the processing temperature of a soldering, a significant reduction of the amount of mechanical stress for the cells is achieved. This allows achieving a particularly low rate of rejected cells and modules in the fabrication process, and a long lifetime of a photovoltaic module. Also, cells having a particularly low thickness can be fabricated without risk of mechanical damage.

If individual wires are attached to the front side surface layer and the back side surface layer, a photovoltaic cell as described with respect to Fig. 1 is obtained. If wires are attached to the front side surface layer, only, a photovoltaic cell as described with respect to Fig. 2 is obtained and, correspondingly, if wires are attached to the back side surface layer, only, a photovoltaic cell as described with respect to Fig. 3 is obtained.

In a module comprising a plurality of electrically connected photovoltaic cells, a transparent cover is typically arranged on the plurality of cells such that in operation of the module, a large amount of electromagnetic radiation reflected back from the wires is advantageously redirected towards the cells by (total) reflection.

It is noted that for fabricating the cell body 1000 as shown in Fig. 10 no screen printing step is used.

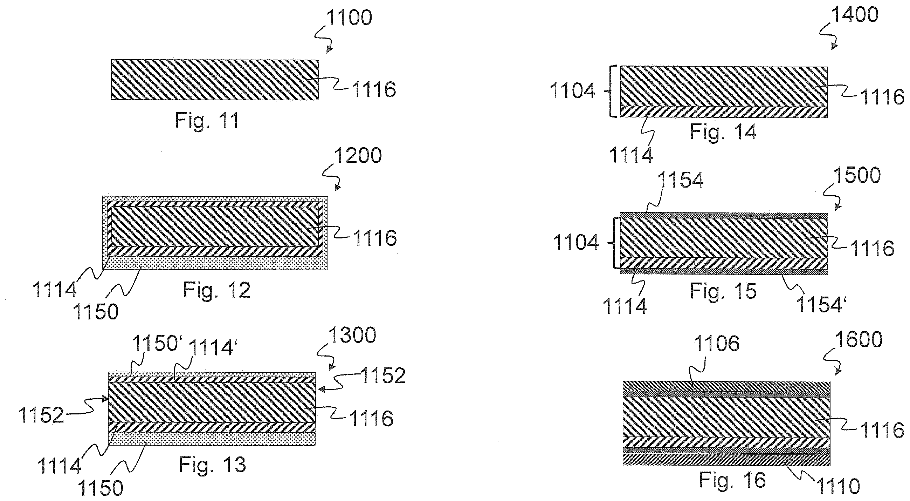

Figures 11 to 16 schematically show another embodiment a method for fabricating a cell body 1600 of a photovoltaic cell by way of a series of intermediate products at different processing stages of the method. In the following, reference will be made to Figs. 11 to 16 in parallel.

Figure 11 shows, as a starting product 1100 of a first processing stage, an n-type silicon wafer 1116, which eventually will serve as a base layer in a semiconductor body 1104 of a cell body 1600 of a photovoltaic cell.

After defect etching and cleaning as well as a step of Boron diffusion from the back side of the wafer 1116, an intermediate cell product 1200 is obtained that comprises a p-doped layer 1114 followed by an oxide layer 1150, both surrounding the n-doped silicon wafer 1116, as shown in Fig. 12.

After an edge isolation step, an intermediate cell product 1300 is obtained in which the oxide layer 1150 as well as the p-doped layer 1114 are removed from the side faces 1152 of the intermediate cell product 1300. Thus, on the front and back side of the silicon wafer 1116, p-doped layers 1114, 1114' are arranged, each covered by an oxide layer 1150, 1150', cf. Fig. 13.

In an oxide etching and cleaning step, the oxide layers 1150, 1150' and the p-doped layer 1114' are removed, such that an intermediate cell product 1400 is obtained from the silicon wafer 1116 that is formed of the semiconductor body 1104 having the p-doped layer 1114 arranged on the back side of the base layer from the wafer 1116, as depicted in Fig. 14. The p-doped layer 1114 arranged on the back side of the wafer 1116 is to form an emitter layer of the cell body 1600.

In a following processing step, conductive passivation layers 1154, 1154' are fabricated on both the front and the back side of the semiconductor body 1104 to protect it against chemical reactions such as oxidation in an ambient atmosphere, shown as an intermediate cell product 1500 in Fig. 15.

The cell body 1600 as shown in Fig. 16 is obtained after having fabricated a transparent conductive oxide (TCO) layer as front side surface layer 1106 and backside surface layer 1110 on the passivation layers 1154, 1154'.

In a subsequent processing step (not shown), electrically conductive wires, e.g., wires as shown in Figs. 17 to 20, are directly attached by means of an electrically conductive adhesive bond, to the front side surface layer 1106 or the back side surface layer 1110 of the cell body 1600 to establish an immediate electrical contact to the front side surface layer 1106 or the backside surface layer 1110 and thus to the cell body 1600. Wires can also be attached by means of an electrically conductive adhesive bond to both the front side surface layer 1106 and the back side surface layer 1110 of the cell body 1600 such that a photovoltaic cell similar to the cell described with respect to Fig. 1 is obtained, keeping in mind that the doping of the base layer and the emitter layer as well as the order of base layer and emitter layer is reversed.

Figures 17 to 20 schematically show cross sectional views of different embodiments of wires 1718, 1818, 1918, 2018 suitable for use in a photovoltaic cell of the present invention. The wires are fabricated to be attached to cell bodies, e.g., as shown in the embodiments of the photovoltaic cells of Figs. 1 to 4. The following description will address Figs. 17 to 20 in parallel.

The wires 1718, 1818, 1918, 2018 shown in Figs. 17 to 20 have a circular shape in cross sectional planes perpendicular to their longitudinal extension. Wires forming alternative and also suitable embodiments but not shown here have another form of a convex shape, such as another round shape, for instance an elliptical shape.

The wires shown in Figs. 17 to 20 all include a respective metal core 1720, 1820, 1920, 2020. In the wire 1700 of Fig. 17 the metal core is surrounded by a single electrically conductive and adhesive wire coat 1722 that can be used to directly attach the wire to a front side surface layer or a backside surface layer of a given cell body by means of an electrically conductive adhesive bond for establishing an immediate electrical contact. In the embodiment of Fig. 18, a non-corrosive plating 1824 is between the metal core 1820 and an electrically conductive and adhesive wire coat 1822. The non-corrosive plating 1824 is useful to establish a more reliable contact to an electrically conductive adhesive 1822 compared to using the metal core 1820 alone. A suitable non-corrosive plating for use with a copper metal core is made of silver.

An adhesive wire coat made of two layers is used in the embodiments of Figs. 19 and 20. The wire 1918 shown in Fig. 19 has its metal core 1920 surrounded by an adhesive wire coat 1922 made of an inner coat layer 1926 directly contacting the metal core 1920 and an outer coat layer 1928 enclosing the inner coat layer 1926 for forming the adhesive bond to the cell body. The wire 2018 of Fig. 20 comprises a metal core 2020 that is additionally surrounded by a non-corrosive plating 2024, as in the embodiment of Fig. 18. The non-corrosive plating 2024 is surrounded by an adhesive wire coat 2022 comprising an inner coat layer 2026 contacting the non-corrosive plating 2024 and an outer coat layer 2028 enclosing the inner coat layer 2026.

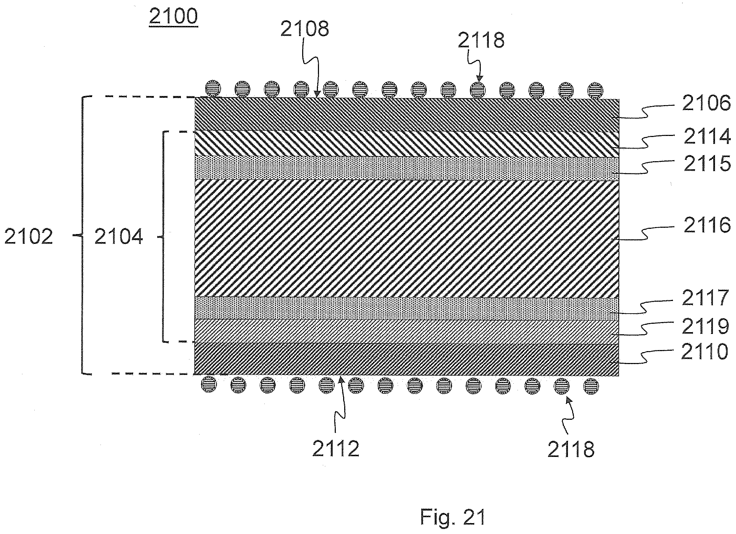

Figure 21 shows a cross sectional view of a further embodiment of a photovoltaic heterojunction cell 2100. The heterojunction cell 2100 has a cell body 2102 that includes a semiconductor body 2104, an electrically conductive front side surface layer 2106 and an electrically conductive back side surface layer 2110.

The electrically conductive front side surface layer 2106 is made of a transparent electrically conductive material such as a TCO. The front side surface layer 2106 is anti-reflective for those spectral components of impinging electromagnetic radiation that are used for the photogeneration of the charge carriers.

The semiconductor body 2104 of the heterojunction cell 2100 comprises, going from top to bottom in the view of Fig. 21, a p-doped layer of hydrogenated amorphous silicon (a-Si:H) 2114, an undoped a-Si:H layer 2115, a crystalline n-doped Silicon body 2116, an undoped a-Si:H layer 2117, and an n-doped a-Si:H layer 2119. The semiconductor body 2104 thus has a relatively thin p-doped emitter layer formed by the p-doped a-Si:H layer 2114 close to a front surface 2108 of the cell body 2102, and a much thicker n-doped base formed by the layers 2116 to 2119 extending to a back surface 2112 of the cell body 2102. The base is the photosensitive region used for photogeneration of charge carriers in response to absorption of electromagnetic radiation.

The electrically conductive back side surface layer 2110 can be made of a transparent electrically conductive material such as a TCO, or of a metal. In both cases, the optical properties of the back side surface layer 2110 support reflection of any electromagnetic radiation impinging on the front side and reaching the back side of the semiconductor body 2104 back into the semiconductor body.

In the exemplary embodiment of Fig. 21, wires 2118 are arranged on both the front side 2108 and the back side 2112 of the cell body 2102. The wires are as in one of the embodiments of Figs. 17 to 20 and thus are directly attached and in immediate electrical contact to the front side surface layer 2106 and the backside surface layer 2110 of the cell body 104, respectively, by means of an electrically conductive adhesive bond. This allows the wires 118 collecting photogenerated charge carriers directly at the front surface or the back surface at any point along the extension of the adhesive bond.

This wiring concept of the photovoltaic cell 2100 simplifies the fabrication process of the heterojunction cell 2100 and of a module comprising the cell in that it requires particularly few fabrication steps. In particular, for fabricating the cell, no metallization is required, and it is not required to perform soldering to establish electrical contact with the front side or back side surface layer of the cell body 2102, nor any electrical contact points between different wires.

In summary, embodiments of a photovoltaic module have been disclosed that comprise a plurality of photovoltaic cells. A cell body of the cells includes an electrically conductive front side surface layer arranged on the semiconductor body. It forms a front surface of the cell body that is transparent for electromagnetic radiation. An electrically conductive back side surface layer is arranged on the semiconductor body and forms a back surface of the cell body. The cells are electrically connected with each other via a plurality of electrically conductive wires that are configured for providing a voltage to an external electrical load in operation of the module. The wires have a convex outer surface and include a metal core and an electrically conductive and adhesive wire coat directly attached and in immediate electrical contact surface of a given cell body by means of an electrically conductive adhesive bond.

## Claims

1. A photovoltaic module (PM) comprising a plurality of photovoltaic cells (400, 400'), each of the cells (400) comprising a cell body (402) including a semiconductor body (404) with a photosensitive region for photogeneration of charge carriers in response to absorption of electromagnetic radiation; wherein
- the cell body (402) includes an electrically conductive front side surface layer (406) that is arranged on the semiconductor body (404) and forms a front surface (408) of the cell body (402) and that is transparent for the impinging electromagnetic radiation used for the photogeneration of the charge carriers, and an electrically conductive back side surface layer (410) that is arranged on the semiconductor body (404) and forms a back surface (412) of the cell body (402);
- the cells (400, 400') are electrically connected with each other via a plurality of electrically conductive wires (418) configured for providing a voltage to an external electrical load in operation of the module;
- the individual wires (418) have a convex outer surface in directions perpendicular to their respective longitudinal wire extension and include a metal core and an electrically conductive and adhesive wire coat that is directly attached and in immediate electrical contact to the front side surface layer (406) or the backside surface layer (410) of a given cell body (402) by means of an electrically conductive adhesive bond.

2. The module of claim 1, wherein the adhesive bond between the individual wires (418) and the front side surface layer (406) or the backside surface layer (410) of a given cell body (402) extends continuously across the front surface (408) or the back surface (412) of the cell body (402) so as to allow the wires collecting photogenerated charge carriers directly at the front surface (408) or the back surface (412) at any point along the extension of the adhesive bond from a first edge (420) to an opposite second edge (420') of the cell body (402).

3. The module of claim 1 or 2, wherein the front side surface layer (406) is anti-reflective for those spectral components of impinging electromagnetic radiation that are used for the photogeneration of the charge carriers.

4. The module at least one of the preceding claims, wherein the back side surface layer (410) is anti-reflective and transparent for those spectral components of impinging electromagnetic radiation that are used for the photogeneration of the charge carriers.

5. The module of one of the claims 1 to 3, wherein the back side surface layer (511) is made of a metal that is resistant to oxidation.

6. The module of at least one of the preceding claims, wherein the cells (400, 400') are electrically connected via the plurality of wires (418) to form a series connection of the cells for providing the voltage to the external electrical load.

7. The module of claim 6, wherein a front set of the wires (418) runs on the front surface (408) of the cell body (402) of a given cell (400) and is guided to the back surface (412') of the cell body (402') of a cell (400') that is next in the series connection.

8. The module of at least one of the preceding claims, wherein the cells comprise 10 to 40 wires per 0,1 meter, counted in a direction perpendicular to a longitudinal extension of the wires.

9. The module of at least one of the preceding claims, wherein the metal core (1720) of the wires is made of copper, aluminum, nickel or an alloy containing at least two of these metals.

10. The module of at least one of the preceding claims, wherein the metal core (1820) is covered by a non-corrosive plating (1824).

11. The module of at least one of the preceding claims, wherein the adhesive wire coat is formed by a single layer (1722) of an electrically conductive adhesive material.

12. The module of at least one of claims 1 to 10, wherein the adhesive wire coat, seen in a cross sectional view, comprises an inner coat layer (1926) contacting the metal core (1920) and an outer coat layer (1928) enclosing the inner coat layer (1926) and forming the adhesive bond to the cell body.

13. The module of at least one of the preceding claims, wherein the semiconductor body (404) is a crystalline silicon body.

14. The module of at least one of the preceding claims, wherein the cell body additionally includes an electrically conductive passivation layer (1154, 1154') arranged directly on a surface of the semiconductor body (1104).

15. A method for fabricating a photovoltaic module comprising a plurality of photovoltaic cells, wherein the method includes the steps of
- for each cell:
- fabricating a cell body including a semiconductor body with a photosensitive region for photogeneration of charge carriers in response to absorption of electromagnetic radiation
- arranging an electrically conductive front side surface layer that is transparent for the impinging electromagnetic radiation used for the photogeneration of the charge carriers on the semiconductor body, thus, forming a front surface of the cell body, and
- arranging an electrically conductive back side surface layer on the semiconductor body, thus, forming a back surface of the cell body; the method further comprising
- electrically connecting the cells via a plurality of electrically conductive wires that have a convex outer surface in directions perpendicular to their respective longitudinal wire extension and include a metal core and an electrically conductive and adhesive wire coat, by forming an adhesive bond between the adhesive wire coat of the individual wires and the front side surface layer or the backside surface layer of a given cell body.

## Patentansprüche

1. Photovoltaikmodul (PM) mit einer Vielzahl Photovoltaikzellen (400, 400'), wobei jede der Zellen (400) einen Zellenkörper (402) aufweist, der einen Halbleiterkörper (404) mit einem photosensitiven Bereich zur Photogenerierung von Ladungsträgern als Reaktion auf eine Absorption elektromagnetischer Strahlung umfasst; wobei
- der Zellenkörper (402) eine auf dem Halbleiterkörper angeordnete elektrisch leitfähige Vorderseitenoberflächenschicht (406) hat, die eine Frontfläche (408) des Zellenkörpers (402) bildet, und die für die zur Photoerzeugung der Ladungsträger verwendete elektromagnetische Strahlung transparent ist, und eine auf dem Halbleiterkörper angeordnete elektrisch leitfähige Rückseitenoberflächenschicht (410) hat, die eine Rückfläche (412) des Zellenkörpers (402) bildet;
- die Zellen (400, 400') mittels einer Vielzahl elektrisch leitfähiger Drähte (418) miteinander elektrisch verbunden und die Drähte ausgebildet sind, im Betrieb des Moduls eine Spannung an eine externe Last bereitzustellen;
- die einzelnen Drähte (418) in Richtungen senkrecht zu ihrer jeweiligen longitudinalen Drahterstreckung eine konvexe äußere Oberfläche haben und einen Metallkern und eine elektrisch leitfähige und adhäsive Drahtummantelung umfassen, die mit der Vorderseitenoberflächenschicht (406) oder der Rückseitenoberflächenschicht (410) eines gegebenen Zellenkörpers (402) mittels einer elektrisch leitfähigen adhäsiven Verbindung unmittelbar verbunden und in unmittelbarem elektrischen Kontakt sind.

2. Modul nach Anspruch 1, wobei sich die adhäsive Verbindung zwischen den einzelnen Drähten (418) und der Vorderseitenoberflächenschicht (406) oder der Rückseitenoberflächenschicht (410) eines gegebenen Zellenkörpers (402) kontinuierlich über die Frontfläche (408) oder die Rückfläche (412) des Zellenkörpers (402) erstreckt, um so den Drähten zu ermöglichen, photogenerierte Ladungsträger unmittelbar an der Frontfläche (408) oder der Rückfläche (412) an einer beliebigen Stelle entlang der Ausdehnung der adhäsiven Verbindung von einem ersten Rand (420) zu einem gegenüberliegenden zweiten Rand (420') des Zellenkörpers (402) zu sammeln.

3. Modul nach Anspruch 1 oder 2, wobei die Vorderseitenoberflächenschicht (406) für diejenigen Spektralkomponenten der auftreffenden elektromagnetischen Strahlung anti-reflektierend ist, die für die Photoerzeugung der Ladungsträger verwendet werden.

4. Modul nach wenigsten einem der vorstehenden Ansprüche, wobei die Rückseitenoberflächenschicht (410) für diejenigen Spektralkomponenten der auftreffenden elektromagnetischen Strahlung anti-reflektierend und transparent ist, die für die Photoerzeugung der Ladungsträger verwendet werden.

5. Modul nach einem der Ansprüche 1 bis 3, wobei die Rückseitenoberflächenschicht (511) aus einem oxidationsbeständigen Metall gebildet ist.

6. Modul nach wenigsten einem der vorstehenden Ansprüche, wobei die Zellen (400, 400') mittels der Vielzahl Drähte (418) zur Bildung einer Reihenschaltung elektrisch verbunden sind, um eine Spannung an die externe elektrische Last bereitzustellen.

7. Modul nach Anspruch 6, wobei ein vorderer Satz Drähte (418) auf der Frontfläche (408) des Zellenkörpers (402) einer gegebenen Zelle (400) verläuft und zur Rückfläche (412') des Zellenkörpers (402') einer in der Reihenschaltung nächsten Zelle (400') geführt ist.

8. Modul nach wenigstens einem der vorstehenden Ansprüche, wobei die Zellen 10 bis 40 Drähte pro 0,1 Meter aufweisen, gezählt in einer Richtung senkrecht zu einer longitudinalen Erstreckung der Drähte.

9. Modul nach wenigstens einem der vorstehenden Ansprüche, wobei der Metallkern (1720) der Drähte aus Kupfer, Aluminium, Nickel oder einer Legierung wenigstens zweier dieser Metalle ist.

10. Modul nach wenigstens einem der vorstehenden Ansprüche, wobei der Metallkern (1820) mit einer nicht-korrodierenden Beschichtung (1824) ummantelt ist.

11. Modul nach wenigstens einem der vorstehenden Ansprüche, wobei die adhäsive Drahtummantelung von einer einzelnen Schicht (1722) eines elektrisch leitfähigen adhäsiven Materials gebildet ist.

12. Modul nach wenigstens einem der Ansprüche 1 bis 10, wobei die adhäsive Drahtummantelung, in einer Querschnittsansicht betrachtet, eine innere Mantelschicht (1926) in Kontakt mit dem Metallkern (1920) und eine die innere Mantelschicht umschließende äußere Mantelschicht (1928) aufweist, welche die adhäsive Verbindung mit dem Zellenkörper bildet.

13. Modul nach wenigstens einem der vorstehenden Ansprüche, wobei der Halbleiterkörper (404) ein kristalliner Siliziumkörper ist.

14. Modul nach wenigstens einem der vorstehenden Ansprüche, wobei der Zellenkörper zusätzlich eine unmittelbar auf einer Oberfläche des Halbleiterkörpers (1104) angeordnete, elektrisch leitfähige Passivierungsschicht (1154, 1154') aufweist.

15. Verfahren zum Herstellen eines Photovoltaikmoduls, welches eine Vielzahl Photovoltaikzellen aufweist, wobei das Verfahren die Schritte aufweist
- für jede der Zellen:
- Herstellen eines Zellenkörpers, der einen Halbleiterkörper mit einem photosensitiven Bereich zur Photogenerierung von Ladungsträgern als Reaktion auf eine Absorption elektromagnetischer Strahlung aufweist,
- Anordnen einer elektrisch leitfähigen Vorderseitenoberflächenschicht auf dem Halbleiterkörper, die eine Frontfläche des Zellenkörpers bildet, und die für die zur Photogenerierung der Ladungsträger verwendete elektromagnetische Strahlung transparent ist, und
- Anordnen einer elektrisch leitfähigen Rückseitenoberflächenschicht auf dem Halbleiterkörper, die eine Rückfläche des Zellenkörpers bildet; wobei das Verfahren weiterhin umfasst
- elektrisches Verbinden der Zellen mittels einer Vielzahl elektrisch leitfähiger Drähte, die in Richtungen senkrecht zu ihrer jeweiligen longitudinalen Drahterstreckung eine konvexe äußere Oberfläche haben und einen Metallkern und eine elektrisch leitfähige und adhäsive Drahtummantelung umfassen, durch Bilden einer adhäsiven Verbindung zwischen der adhäsiven Drahtummantelung der einzelnen Drähte und der Vorderseitenoberflächenschicht oder der Rückseitenoberflächenschicht eines gegebenen Zellenkörpers.

## Revendications

1. Un module photovoltaïque (PM) comprenant une pluralité de cellules photovoltaïques (400, 400'), chacune des cellules (400) comprenant un corps de cellule (402) comprenant un corps semi-conducteur (404) avec une région photosensible pour la photogénération des porteurs de charge en réponse à l'absorption du rayonnement électromagnétique ; dans lequel
- le corps de cellule (402) comprend une couche de surface latérale avant électriquement conductrice (406) qui est disposé sur le corps semi-conducteur (404) et forme une surface avant (408) du corps de cellule (402) et qui est transparent pour le rayonnement électromagnétique le frappant utilisé pour la photogénération des porteurs de charge, et une couche de surface latérale arrière électriquement conductrice (410) qui est disposée sur le corps semi-conducteur (404) et forme une surface arrière (412) du corps de cellule (402) ;
- les cellules (400, 400') sont reliées électriquement les unes aux autres via une pluralité de fils électriquement conducteurs (418) configurés pour fournir une tension à une charge électrique externe en fonctionnement du module ;
- les fils individuels (418) ont une surface extérieure convexe dans des directions perpendiculaires à leur extension de fil longitudinale respective et comprennent un noyau métallique et un revêtement de fil adhésif et conducteur de l'électricité qui est directement attaché et en contact électrique immédiat avec la couche de surface latérale avant (406) ou la couche de surface arrière (410) d'un corps de cellule donné (402) au moyen d'un lien adhésif électriquement conducteur.

2. Le module de la revendication 1, dans lequel le lien adhésif entre les fils individuels (418) et la couche de surface latérale avant (406) ou la couche de surface arrière (410) d'un corps de cellule donné (402) s'étend en continu sur la surface avant (408) ou la surface arrière (412) du corps de cellule (402) afin de permettre aux fils de collecter des porteurs de charge photogénérés directement à la surface avant (408) ou à la surface arrière (412) en tous points le long de l'extension du lien adhésif d'un premier bord (420) au deuxième bord opposé (420') du corps de cellule (402).

3. Le module de la revendication 1 ou 2, dans lequel la couche de surface latérale avant (406) est anti-réfléchissante pour les composants spectraux du rayonnement électromagnétique la frappant qui sont utilisés pour le photogénération des porteurs de charges.

4. Le module selon au moins l'une des revendications précédentes, dans lequel la couche de la surface latérale arrière (410) est anti-réfléchissante et transparente pour les composants spectraux du rayonnement électromagnétique la frappant utilisés pour la photogénération des porteurs de charge.

5. Le module de l'une des revendications 1 à 3, dans lequel la couche de surface latérale arrière (511) est faite d'un métal résistant à l'oxydation.

6. Le module selon au moins l'une des revendications précédentes, dans lequel les cellules (400, 400') sont reliées électriquement par la pluralité des fils (418) pour former une connexion en série de la cellule en vue de fournir la tension à la charge électrique externe.

7. Le module de la revendication 6, dans lequel un ensemble avant des fils (418) passe sur la surface avant (408) du corps de cellule (402) d'une cellule donnée (400) et est guidé vers la surface arrière (412') du corps de cellule (402') de la cellule (400') qui est la suivante dans la série de connexions.

8. Le module selon au moins l'une des revendications précédentes, dans lequel les cellules comprennent 10 à 40 fils par 0,1 mètre, déterminés selon la direction perpendiculaire à une extension longitudinale des fils.

9. Le module selon au moins l'une des revendications précédentes, dans lequel le noyau métallique (1720) des fils est fait de cuivre, d'aluminium, de nickel ou d'un alliage contenant au moins deux ces métaux.

10. Le module selon au moins l'une des revendications précédentes, dans lequel le noyau métallique (1820) est recouvert d'un placage non corrosif (1824).

11. Le module selon au moins l'une des revendications précédentes, dans lequel le revêtement de fil adhésif est formée par une seule couche (1722) d'un matériau adhésif électriquement conducteur.

12. Le module selon au moins une des revendications 1 à 10, dans lequel le revêtement de fil adhésif, vu selon une coupe transversale, comprend une couche de revêtement interne (1926) au contact du métal (1920) et une couche de revêtement externe (1928) enveloppant la couche de revêtement intérieure (1926) et formant le lien adhérant au corps de cellule.

13. Le module selon au moins l'une des revendications précédentes, dans lequel le corps semi-conducteur (404) est un corps de silicium cristallin.

14. Le module selon au moins l'une des revendications précédentes, dans lequel le corps de cellule comprend en outre une couche de passivation électriquement conductrice (1154, 1154') disposée directement sur une surface du corps semi-conducteur (1104).

15. Une méthode de fabrication d'un module photovoltaïque comprenant une pluralité de cellules photovoltaïques, dans laquelle le procédé comprend les étapes:
- pour chaque cellule :
- de fabrication d'un corps de cellule comprenant un corps semi-conducteur avec une région photosensible pour la photogénération des porteurs de charge en réponse à l'absorption du rayonnement électromagnétique
- d'organisation d'une couche de surface latérale avant électriquement conductrice qui est transparente pour le rayonnement électromagnétique le frappant utilisé pour la photogénération des porteurs de charge sur le corps semi-conducteur, donc formant une surface avant du corps de cellule, et
- d'organisation d'une couche de surface latérale arrière conductrice électrique sur le corps semi-conducteur, donc formant une surface arrière du corps de cellule ; le procédé comprenant en outre
- la connexion électrique des cellules par l'intermédiaire d'une pluralité de fils électriques conducteurs qui ont une surface extérieure convexe dans des directions perpendiculaires à l'extension longitudinale du fil respectif et comprennent un noyau métallique et une couche métallique électriquement conductrice et adhésive, formant ainsi un lien adhésif entre le revêtement de fil adhésif des fils individuels et la couche de surface latérale avant ou la couche de surface arrière d'un corps de cellule donné.
